# EUROPEAN PATENT SPECIFICATION

(11) **EP 4 390 985 B1**
(45) Date of publication and mention of the grant of the patent: **10.09.2025**
(21) Application number: 22383252.8
(22) Date of filing: 21.12.2022
(51) Int. Cl.: H01F 17/06, H01F 27/02, H01F 27/22, H01F 27/38, H01F 27/40, H01F 27/28, H01F 17/04

(54) **AN ELECTROMAGNETIC FILTER FOR OPERATING IN COMMON AND DIFFERENTIAL MODE**
ELEKTROMAGNETISCHES FILTER ZUM BETRIEB IM GLEICHTAKT- UND GEGENTAKTBETRIEB
FILTRE ÉLECTROMAGNÉTIQUE POUR UN FONCTIONNEMENT EN MODE COMMUN ET DIFFÉRENTIEL

(43) Date of publication of application: 26.06.2024
(73) Proprietor: Premo, SL, 29590 Campanillas, Málaga (ES)
(72) Inventor: CUESTA CANO, Juan Miguel, 29006 Málaga (ES); PÉREZ CAMERO, Paula, 29790 Chilches, Vélez-Málaga (ES); ROJAS CUEVAS, Antonio, 29190 Málaga (ES); CAÑETE CABEZA, Claudio, 29631 Benalmádena (ES); NAVARRO PÉREZ, Francisco Ezequiel, 08006 Barcelona (ES)
(74) Representative: Torner, Juncosa I Associats, SL

(56) References cited:
- EP-A1- 3 428 937
- US-A- 3 872 399
- US-A1- 2007 257 759
- US-A1- 2008 055 035

## Description

### Technical field

The proposed invention is related to the field of electromagnetic noise passive filters or EMC filters to reduce electromagnetic interferences or EMI/RFI. More in particular, the invention relates to an electromagnetic filter for operating in both common and differential mode, which is characterized by its particular structure that provides a set of high compactness.

### Background of the Invention

An EMC filter is known by Chinese patent application CN103545085A. In said document a double-magnetic-core difference-common mode integrated EMC filter is disclosed. The filter comprises two identical magnetic cores and four coils; the magnetic core is a closed magnetic core; an air gap is reserved between the two magnetic cores; the two common-mode inductance coils are wound on the two magnetic cores in a sharing mode, the two differential-mode inductance coils are wound on the two magnetic cores respectively, and the homonymous terminal of the first differential-mode inductance coil is connected with the homonymous terminal of the first common-mode inductance coil; the homonymous terminal of the second differential-mode inductance coil is connected with the heteronymous terminal of the second common-mode inductance coil.

In another possible embodiment, the EP3493228B1 discloses an annular magnetic power unit comprising: a first partial magnetic core and a second partial magnetic core overlapped and facing to each other, said first partial magnetic core having a first annular groove accessible through a surface of the first partial magnetic core; at least one electro-conductive inner coil included within the annular groove; and at least one electro-conductive outer coil wound around the annular magnetic core. The at least one electro-conductive outer coil is formed by two independent electro-conductive outer coils named left and right independent electro-conductive outer coils and the first partial magnetic core is divided by two parallel air-gaps in three independent parts corresponding to a first central magnetic core portion, defined between said two parallel air-gaps, to a first left-side core portion and to a first right-side core portion placed on both sides of said first central magnetic core portion. The second partial magnetic core is also divided by said two parallel air-gaps in three independent parts corresponding to a second central magnetic core portion, defined between said two parallel air-gaps.

US2008055035 discloses an interference suppression coil with a toroidal core and a coil around it, wherein a capacitor may be placed in the inner hollow part of the core.

US3872399 discloses a LC filter with a toroidal core and a coil around it, wherein a capacitor is also placed inside the middle of the core.

US2007257759 discloses a common mode choke with a toroidal core and coils around it, enclosed by a magnetic body made of resin and magnetic filler.

EP34289374 discloses a hollow toroidal magnetic power unit with two coils wound around a toroidal core and a third toroidal coil wound inside the hollow core.

### Description of the Invention

An object of the present invention is to provide an electromagnetic filter to operate in both common and differential mode and which increases leakage inductance and improves thermal link to a customer cooling plate.

To that end, the proposed filter of the invention comprises a toroidal-like magnetic core and first and second separated coils that are wound around the toroidal-like magnetic core, the first and second separated coils and the toroidal-like magnetic core being configured to provide a common mode filter.

According to this invention, the first and second separated coils are arranged in opposition to each other and around two major separated segments of the toroidal-like magnetic core.

Moreover, the electromagnetic filter further comprises: a third coil that is arranged to surround the toroidal-like magnetic core and the first and second separated coils and arranged around a Z axis that is coaxial with an inner hollow part of the toroidal-like magnetic core, the third coil being configured to provide a filter operating in differential mode; a capacitor; two sheets arranged between opposite external faces of the capacitor to thermally isolate the capacitor from the first and second separated coils; the capacitor and the two sheets being arranged inside the inner hollow part of the toroidal-like magnetic core; and a layer of a thermal conductive magnetic compound configured to enclose/encapsulate the toroidal-like magnetic core, the first, second and third coils, the capacitor, and the two sheets to: increase leakage inductance, to enclose/encapsulate the magnetic field generated by the third coil, and also to provide good thermal link to the customer cooling plate.

According to the invention, the toroidal-like magnetic core can be oval and elongated, or elliptic.

In some embodiments, the material of the two sheets is made of a polystyrene material or similar.

In some embodiments, the toroidal-like magnetic core is a nanocrystalline structure core.

The proposed filter improves differential mode attenuation. In some embodiments, compared to the classical solutions, said attenuation can be more than 20dB @100k-1MHz. The proposed filter also provides good mechanical interfaces and thermal link with customer housing and cooling system.

### Brief description of the Figures

The foregoing and other advantages and features will be more fully understood from the following detailed description of an embodiment with reference to the accompanying drawings, to be taken in an illustrative and non-limitative manner, in which:
Figs.1A and 1B illustrate an electromagnetic filter for operating in common and differential mode, according to an embodiment of the present invention. Fig. 1C is a schematic diagram of the proposed filter with the capacitor and coils.
Figs.2A and 2B are different views of the electromagnetic filter with all the components/elements thereof assembled. The spatial position of each component/element that forms the compact electromagnetic filter of the invention can be appreciated. The electrical connections of each electronic component can also be seen in detail.

### Detailed Description of the Invention and of particular embodiments

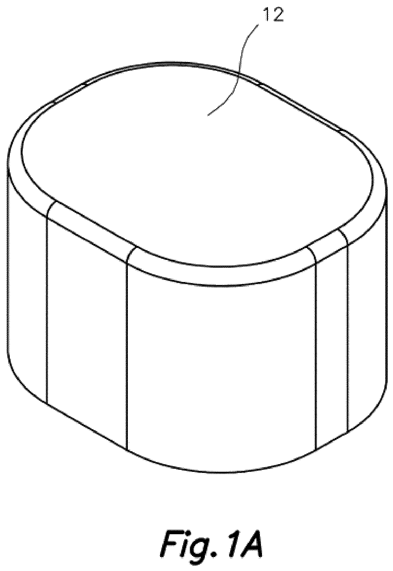

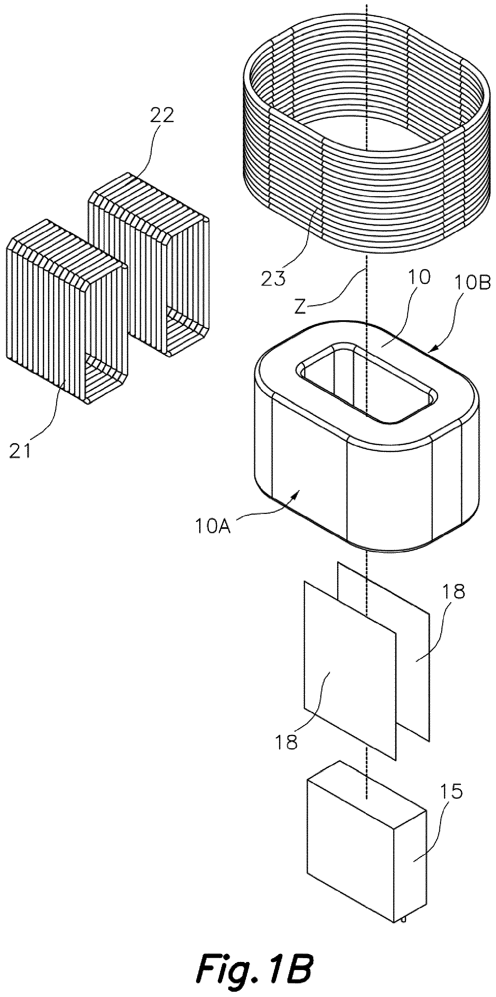

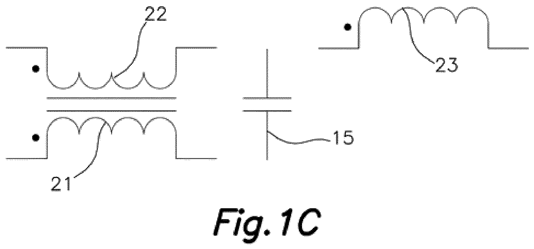

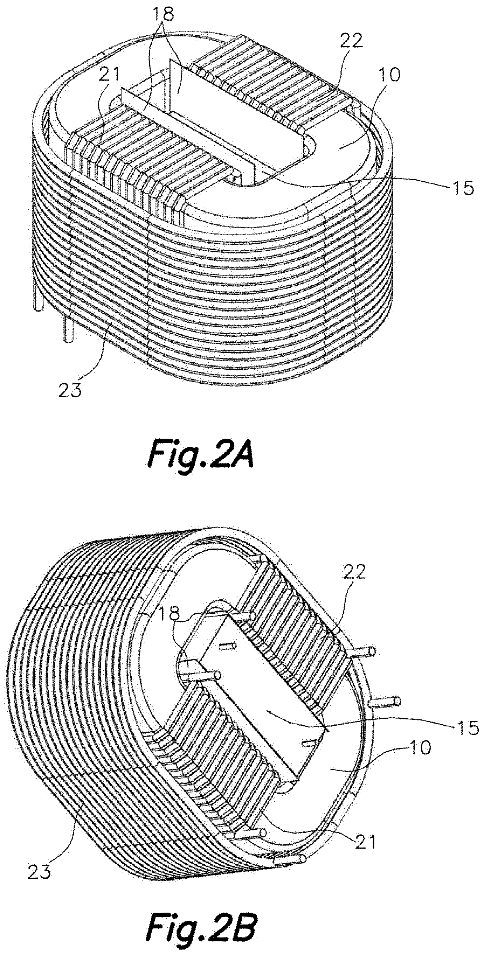

Figs. 1A and 1B and 2A and 2B show an embodiment of the proposed electromagnetic filter. As seen in the figures, the electromagnetic filter comprises a nanocrystalline toroidal-like magnetic core 10, a first 21 coil, a second 22 coil, a third coil 23, a capacitor 15 and two sheets 18, which are preferably made of a polystyrene material.

As seen in Fig. 1A, all the cited elements/components of the electromagnetic filter, once assembled/gathered, are enclosed/encapsulated by a layer of a thermal conductive magnetic compound 12. Because of this enclosure, leakage inductance is enhanced, and the magnetic field generated by the third 23 coil can be enclosed. It also provides good thermal link to the customer cooling plate.

Particularly, the first and second coils 21, 22 and the toroidal-like magnetic core 10 are configured to operate as a common mode filter. The third 23 coil and the capacitor 15 is configured to operate as a differential mode filter. Therefore, the electromagnetic filter can operate in both modes (i.e., dual mode).

The first 21 and second 22 coils are separated between them and arranged in opposition to each other. Likewise, the two coils 21, 22, when assembled (as can be seen in Figs. 2A and 2B), are arranged around two major separated segments 10A, 10B of the toroidal-like magnetic core 10.

The third 23 coil is arranged to surround the toroidal-like magnetic core 10, the first 21 coil, and the second 22 coil around a Z axis that is coaxial with an inner hollow part of the toroidal-like magnetic core 10.

The capacitor 15, when assembled, is sandwiched by the two sheets 18. Moreover, the capacitor 15 and the two sheets 18 are arranged inside the inner hollow part of the toroidal-like magnetic core 10. The two sheets 18 allow thermally isolating the capacitor 15 from the first and second coils 21, 22.

The first, second and third coils 21, 22 and 23 are thermally isolated between them and the capacitor 15 to ensure safety operation. The first, second and third coils 21, 22 and 23 are also electrically isolated.

It should be noted that in other embodiments, not illustrated, the proposed electromagnetic filter can include more than one capacitor.

The following table summarizes some of the characteristics the electromagnetic filter may have. In a particular embodiment, the electromagnetic filter is designed to operate according to the AEC-Q200 standard being such characteristics as follows:

| | |
|---|---|
| Rated current | 16Arms |
| Rated voltage | 630Vdc |
| MAX Dimensions | 55x45x35mm |
| CMC Inductance | 21mH @10kHz |
| CMC Inductance | 5mH@100kHz |
| CMC Llkg | > 30uH @100kHz |
| CMC DCR | < 10mΩ |
| DM Inductance | 32uH@10kHz |
| Cx capacitor | 1,0uF |
| Withstand voltage | 2000Vac 50Hz 60s |
| Operating ambient temperature | -40ºC to +105ºC |

The scope of the present invention is defined in the following set of claims.

## Claims

1. An electromagnetic filter configured to be able to operate in common and differential mode, comprising:
a toroidal-like magnetic core (10);
first (21) and second (22) separated coils wound around the toroidal-like magnetic core (10), the first and second separated coils (21, 22) and the toroidal-like magnetic core (10) being configured to provide a common mode filter,
**characterized in that**:
the first (21) and second (22) separated coils are arranged in opposition to each other and around two major separated segments (10A, 10B) of the toroidal-like magnetic core (10);
and **in that** the electromagnetic filter further comprises:
a third (23) coil that is arranged to surround the toroidal-like magnetic core (10) and the first (21) and second (22) separated coils and arranged around a Z axis that is coaxial with an inner hollow part of the toroidal-like magnetic core (10), the third (23) coil being configured to provide a filter operating in differential mode;
at least one capacitor (15);
two sheets (18) arranged between opposite external faces of the capacitor (15) to thermally isolate the capacitor (15) from the first (21) and second (22) separated coils;
the capacitor (15) and the two sheets (18) being arranged inside the inner hollow part of the toroidal-like magnetic core (10); and
a layer of a thermal conductive magnetic compound (12) configured to enclose the toroidal-like magnetic core (10), the first (21), second (22) and third (23) coils, the capacitor (15) and the two sheets (18), such that leakage inductance is increased, a magnetic field generated by the third (23) coil is enclosed, and a good thermal link to a cooling plate is provided.

2. The electromagnetic filter according to claim 1, wherein the toroidal-like magnetic core (10) is oval and elongated.

3. The electromagnetic filter according to claim 1, wherein the toroidal-like magnetic core (10) is elliptical.

4. The electromagnetic filter according to any one of the previous claims, wherein the third (23) coil is arranged perpendicularly with respect to the first (21) and second (22) separated coils.

5. The electromagnetic filter according to any one of the previous claims, wherein the third (23) coil is decoupled with regard to the first (21) and second (22) separated coils.

6. The electromagnetic filter according to any one of the previous claims, wherein the two sheets (18) are made of a polystyrene material.

7. The electromagnetic filter according to any one of the previous claims, wherein the toroidal-like magnetic core (10) is a nanocrystalline core.

## Patentansprüche

1. Elektromagnetischer Filter, der dazu konfiguriert ist, im Gleichtakt- und Differentialmodus arbeiten zu können, Folgendes umfassend:
einen toroidartigen Magnetkern (10);
erste (21) und zweite (22) getrennte Spulen, die um den toroidartigen Magnetkern (10) gewickelt sind, wobei die erste und zweite getrennten Spulen (21, 22) und der toroidartige Magnetkern (10) dazu konfiguriert sind, einen Gleichtaktfilter bereitzustellen,
**dadurch gekennzeichnet, dass**:
die erste (21) und die zweite (22) getrennten Spulen einander gegenüber und um zwei getrennte Hauptsegmente (10A, 10B) des toroidartigen Magnetkerns (10) herum angeordnet sind; und dass das elektromagnetische Filter ferner Folgendes umfasst:
eine dritte (23) Spule, die angeordnet ist, um den toroidartigen Magnetkern (10) und die erste (21) und die zweite (22) getrennten Spulen zu umgeben, und die um eine Z-Achse angeordnet ist, die koaxial mit einem inneren hohlen Teil des toroidartigen Magnetkerns (10) ist, wobei die dritte (23) Spule dazu konfiguriert ist, einen Filter bereitzustellen, der im Differenzmodus arbeitet;
mindestens einen Kondensator (15);
zwei Platten (18), die zwischen gegenüberliegenden Außenflächen des Kondensators (15) angeordnet sind, um den Kondensator (15) von der ersten (21) und zweiten (22) getrennten Spulen thermisch zu isolieren;
wobei der Kondensator (15) und die beiden Platten (18) innerhalb des inneren hohlen Teils des toroidartigen Magnetkerns (10) angeordnet sind; und
eine Schicht aus einer wärmeleitenden magnetischen Verbindung (12), die dazu konfiguriert ist, den toroidartigen Magnetkern (10), die erste (21), zweite (22) und dritte (23) Spule, den Kondensator (15) und die beiden Platten (18) zu umschließen, sodass die Streuinduktivität erhöht wird, ein von der dritten (23) Spule generiertes Magnetfeld eingeschlossen wird und eine gute thermische Verbindung zu einer Kühlplatte bereitgestellt wird.

2. Elektromagnetischer Filter nach Anspruch 1, wobei der toroidartige Magnetkern (10) oval und langgestreckt ist.

3. Elektromagnetischer Filter nach Anspruch 1, wobei der toroidartige Magnetkern (10) elliptisch ist.

4. Elektromagnetischer Filter nach einem der vorhergehenden Ansprüche, wobei die dritte (23) Spule senkrecht in Bezug auf die erste (21) und zweite (22) getrennten Spulen angeordnet ist.

5. Elektromagnetischer Filter nach einem der vorhergehenden Ansprüche, wobei die dritte (23) Spule in Bezug auf die erste (21) und die zweite (22) getrennten Spulen entkoppelt ist.

6. Elektromagnetischer Filter nach einem der vorhergehenden Ansprüche, wobei die beiden Platten (18) aus einem Polystyrolmaterial hergestellt sind.

7. Elektromagnetischer Filter nach einem der vorhergehenden Ansprüche, wobei der toroidartige Magnetkern (10) ein nanokristalliner Kern ist.

## Revendications

1. Filtre électromagnétique configuré pour être capable d'un fonctionnement en mode commun et différentiel, comprenant :
un noyau magnétique de type toroïdal (10) ;
une première (21) et une deuxième (22) bobines séparées enroulées autour du noyau magnétique de type toroïdal (10), la première (21) et la deuxième (22) bobines séparées et le noyau magnétique de type toroïdal (10) étant configurés pour fournir un filtre en mode commun,
**caractérisé en ce que** :
la première (21) et la deuxième (22) bobines séparées sont disposées opposées l'une à l'autre et autour de deux segments séparés principaux (10A, 10B) du noyau magnétique de type toroïdal (10) ; et **en ce que** le filtre électromagnétique comprend en outre :
une troisième (23) bobine qui est disposée pour entourer le noyau magnétique de type toroïdal (10) et la première (21) et la deuxième (22) bobines séparées et disposée autour d'un axe Z qui est coaxial à une partie creuse intérieure du noyau magnétique de type toroïdal (10), la troisième (23) bobine étant configurée pour fournir un filtre fonctionnant en mode différentiel ;
au moins un condensateur (15) ;
deux feuilles (18) disposées entre des faces externes opposées du condensateur (15) pour isoler thermiquement le condensateur (15) de la première (21) et la deuxième (22) bobines séparées ;
le condensateur (15) et les deux feuilles (18) étant disposés à l'intérieur de la partie creuse intérieure du noyau magnétique de type toroïdal (10) ; et
une couche d'un composé magnétique thermiquement conducteur (12) configuré pour enfermer le noyau magnétique de type toroïdal (10), la première (21), la deuxième (22) et la troisième (23) bobines, le condensateur (15) et les deux feuilles (18), de telle sorte que l'inductance de fuite est augmentée, un champ magnétique généré par la troisième (23) bobine est enfermé, et une bonne liaison thermique à une plaque de refroidissement est fournie.

2. Filtre électromagnétique selon la revendication 1, dans lequel le noyau magnétique de type toroïdal (10) est ovale et allongé.

3. Filtre électromagnétique selon la revendication 1, dans lequel le noyau magnétique de type toroïdal (10) est elliptique.

4. Filtre électromagnétique selon l'une quelconque des revendications précédentes, dans lequel la troisième (23) bobine est disposée perpendiculairement par rapport à la première (21) et la deuxième (22) bobines séparées.

5. Filtre électromagnétique selon l'une quelconque des revendications précédentes, dans lequel la troisième (23) bobine est découplée par rapport à la première (21) et la deuxième (22) bobines séparées.

6. Filtre électromagnétique selon l'une quelconque des revendications précédentes, dans lequel les deux feuilles (18) sont réalisées en un matériau de polystyrène.

7. Filtre électromagnétique selon l'une quelconque des revendications précédentes, dans lequel le noyau magnétique de type toroïdal (10) est un noyau nanocristallin.
